# EUROPEAN PATENT APPLICATION

(11) **EP 4 456 694 A1**
(43) Date of publication of application: **30.10.2024**
(21) Application number: 22910751.1
(22) Date of filing: 25.11.2022
(51) Int. Cl.: H10K 30/50

(54) **PHOTOELECTRIC CONVERSION ELEMENT**

(30) Priority: 24.12.2021 JP 2021211204
(71) Applicant: Zeon Corporation, Tokyo 100-8246 (JP)
(72) Inventor: KOMIYA, Ryoichi, Tokyo 100-8246 (JP)
(74) Representative: Maiwald GmbH
(86) International application number: PCT/JP2022/043594
(87) International publication number: WO 2023/120033

(57) **Abstract**

A photoelectric conversion element (100) formed of an integrated laminate including a translucent base plate (1), a transparent conductive film (2), a first conductive layer (5), a power generation layer (6), and a second conductive layer (7) in this order, wherein the second conductive layer (7) consists of a porous layer (4) containing at least a carbon nanotube fiber body, and a polymeric layer (8) formed of a polymer with a weight-average molecular weight of 20,000 or more and 200,000 or less is provided between the power generation layer (6) and the second conductive layer (7).

## Description

### TECHNICAL FIELD

This disclosure relates to a photoelectric conversion element.

### BACKGROUND

Solar cells have attracted attention as photoelectric conversion elements that convert light energy into electricity. Examples of solar cells include various types of solar cells such as a perovskite solar cell that uses a perovskite compound as a power generation layer.

For example, PTL 1 (JP6339037B2) proposes a photoelectric conversion element including; a first electrode; a second electrode including a substrate containing a plurality of structures including carbon and a first material part provided between the plurality of structures and containing a carrier transport material; a photoelectric conversion layer provided between the first electrode and the second electrode and containing a material having a perovskite structure; and a first layer provided between the photoelectric conversion layer and the second electrode and containing a carrier transport material.

### CITATION LIST

### Patent Literature

PTL 1: JP6339037B2

### SUMMARY

### (Technical Problem)

However, conventional photoelectric conversion elements have room for improvement in structural stability.

It could be helpful to provide a photoelectric conversion element with excellent structural stability.

### (Solution to Problem)

The presently disclosed photoelectric conversion element is a photoelectric conversion element formed of an integrated laminate including a translucent base plate, a transparent conductive film, a first conductive layer, a power generation layer, and a second conductive layer in this order, wherein the second conductive layer consists of a porous layer containing at least a carbon nanotube fiber body, and a polymeric layer formed of a polymer with a weight-average molecular weight of 20,000 or more and 200,000 or less is provided between the power generation layer and the second conductive layer. With such configuration, a photoelectric conversion element with excellent structural stability can be provided.

In the presently disclosed photoelectric conversion element, the polymer is preferably a hydrogenated polymer. With such configuration, the structural stability of the photoelectric conversion element can be more improved.

In the presently disclosed photoelectric conversion element, the polymer is preferably a polymer having a hydrogenated aromatic or diene skeleton at the main chain. With such configuration, the structural stability of the photoelectric conversion element can be more improved.

In the presently disclosed photoelectric conversion element, the polymer is preferably one or more selected from the group consisting of a hydrogenated aromatic vinyl compound-conjugated diene block copolymer and a modified product by a silicon atom-containing polar group of a hydrogenated aromatic vinyl compound-conjugated diene block copolymer. With such configuration, the structural stability of the photoelectric conversion element can be more improved.

In the presently disclosed photoelectric conversion element, the hydrogenated aromatic vinyl compound-conjugated diene block copolymer preferably has a structure with both of the non-aromatic carbon-carbon unsaturated bond and the aromatic carbon-carbon unsaturated bond hydrogenated. With such configuration, the structural stability of the photoelectric conversion element can be more improved.

In the presently disclosed photoelectric conversion element, the second conductive layer preferably consists of a porous self-supporting sheet. With such configuration, the production of the photoelectric conversion element is promoted, and the structural stability can be more improved.

In the present disclosure, the "porous self-supporting sheet" refers to a sheet on which a plurality of pores are formed, a sheet keeping the shape as a sheet even without a support. The porous self-supporting sheet used in this disclosure maintains the shape as a sheet with no breaks of the sheet even when, after this porous self-supporting sheet is immersed in a predetermined solvent or solution and then pulled up, this porous self-supporting sheet is affixed to an affixed body. Moreover, the porous self-supporting sheet used in this disclosure has no breaks and deformation of the sheet even when, for example, chlorobenzene to be a poor solvent for the perovskite compound is dropped on the sheet or the sheet is treated using a jig used for affixing the sheet. Furthermore, the porous self-supporting sheet used in this disclosure preferably keeps the shape as a sheet without a support, in a size, for example, with a film thickness of 1 µm to 200 µm and an area of 1 mm² to 100 cm².

In the presently disclosed photoelectric conversion element, the porous self-supporting sheet preferably has a film thickness of 20 µm or more. With such configuration, the production of the photoelectric conversion element is facilitated, and the structural stability can be more improved.

In the presently disclosed photoelectric conversion element, the power generation layer preferably contains a perovskite compound. With such configuration, the production cost of the photoelectric conversion element can be reduced, and the ease of production of the photoelectric conversion element can be improved.

In the presently disclosed photoelectric conversion element, the carbon nanotube fiber body preferably has an average diameter (Av) and a standard deviation (σ) of the diameter that satisfy a relationship 0.20 < (3σ/Av) < 0.60. With such configuration, the structural stability of the photoelectric conversion element can be more improved.

The "average diameter (Av) of the carbon nanotube fiber body" and the "standard deviation (σ: standard deviation) of the diameter of the carbon nanotube fiber body" can be each determined by measuring the diameters (outer diameters) of 100 carbon nanotube fiber bodies randomly selected using a transmission electron microscope. The average diameter (Av) and the standard deviation (σ) of the carbon nanotube fiber body may be adjusted by changing the production method or production conditions of the carbon nanotube fiber body or may be adjusted by combining a plurality of types of carbon nanotube fiber bodies obtained by different production methods.

In the presently disclosed photoelectric conversion element, the carbon nanotube fiber body preferably has a t-plot obtained from the adsorption isotherm that exhibits a convex upward shape. With such configuration, the structural stability of the photoelectric conversion element can be more improved.

The presently disclosed photoelectric conversion element is preferably produced by a method including a step of, after stacking the polymeric layer on the power generation layer, in a state where at least one joining surface of a porous self-supporting sheet to be the second conductive layer, and the polymeric layer keeps a solvent, stacking the porous self-supporting sheet on the polymeric layer. With such configuration, a photoelectric conversion element with ease of production and excellent structural stability can be easily produced.

The presently disclosed photoelectric conversion element is preferably produced by a method including a step of, in a state where at least one joining surface of a porous self-supporting sheet to be the second conductive layer, and the power generation layer keeps a solution in which a polymer to form the polymeric layer is dissolved, stacking the porous self-supporting sheet on the power generation layer. With such configuration, a photoelectric conversion element with ease of production and excellent structural stability can be easily produced.

### (Advantageous Effect)

According to the present disclosure, a photoelectric conversion element with excellent structural stability can be provided.

### BRIEF DESCRIPTION OF THE DRAWINGS

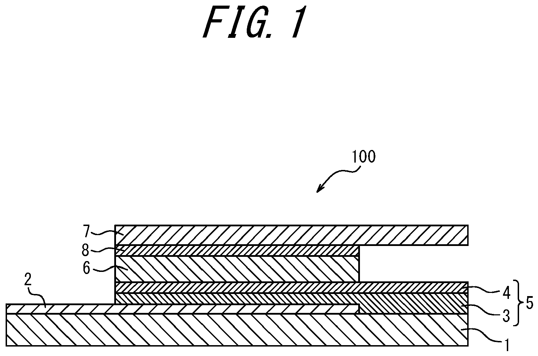

In the accompanying drawings: FIG. 1 is a cross-sectional view that schematically illustrates a configuration of a photoelectric conversion element according to one of the disclosed embodiments.

### DETAILED DESCRIPTION

A photoelectric conversion element of the present disclosure can be used as, for example, a perovskite solar cell, without any specific limitations. One of the embodiments of the presently disclosed photoelectric conversion element will be described in detail with reference to FIG. 1.

### (Photoelectric conversion element)

FIG. 1 is a cross-sectional view that schematically illustrates a configuration of a photoelectric conversion element 100 according to one of the embodiments. The photoelectric conversion element 100 is formed of an integrated laminate including a translucent base plate 1, a transparent conductive film 2, a first conductive layer 5 consisting of a foundation layer 3 and a porous semiconductor layer 4, a power generation layer 6, and a second conductive layer 7 in this order. The second conductive layer 7 consists of a porous self-supporting sheet as a porous layer containing at least a carbon nanotube fiber body. A polymeric layer 8 formed of a polymer with a weight-average molecular weight of 20,000 or more and 200,000 or less is provided between the power generation layer 6 and the second conductive layer 7. The respective components that constitute the photoelectric conversion element 100 will be described in sequence.

### <Translucent base plate 1>

The translucent base plate 1 constitutes a base of the photoelectric conversion element 100. Examples of the translucent base plate 1 include, but are not specifically limited to, a base plate formed of glass or a synthetic resin, and a film formed of a synthetic resin.

Examples of the glass that constitutes the translucent base plate 1 include mineral glass such as soda glass.

Examples of the synthetic resin that constitutes the translucent base plate 1 include a polyacrylic resin, a polycarbonate resin, a polyester resin, a polyimide resin, a polystyrene resin, a polyvinyl chloride resin, a polyamide resin, and a polycycloolefin resin. Of these synthetic resins, from a viewpoint of obtaining a thin, light, and flexible photoelectric conversion element 100, polyethylene terephthalate (PET) and polyethylene naphthalate (PEN) are preferable as the synthetic resin.

No specific limitations are placed on the thickness of the translucent base plate 1. The translucent base plate 1 may have a thickness that can maintain the shape as a base plate. The thickness of the translucent base plate 1 can be set to, for example, 0.1 mm or more and 10 mm or less.

### <Transparent conductive film 2>

The transparent conductive film 2 is a film formed of metal oxide formed on the surface of the translucent base plate 1. Providing the transparent conductive film 2 can apply electrical conductivity to the surface of the translucent base plate 1.

Examples of the metal oxide that constitutes the transparent conductive film 2 include fluorine-doped tin oxide (FTO), tin oxide (SnO), indium oxide (In₂O₃), tin-doped indium oxide (ITO), zinc oxide (ZnO), indium oxide/zinc oxide (IZO), and gallium oxide/zinc oxide (GZO). In the photoelectric conversion element 100 illustrated in FIG. 1, the number of the transparent conductive film 2 on the translucent base plate 1 is one. However, the number of the transparent conductive film 2 on the translucent base plate 1 may be two or more. When the photoelectric conversion element 100 has two or more transparent conductive films 2, the respective transparent conductive films may be formed of identical metal oxide or mutually different metal oxides.

No specific limitations are placed on the film thickness of the transparent conductive film 2 so long as it can apply desired electrical conductivity to the translucent base plate 1. The film thickness of the transparent conductive film 2 can be set to, for example, 1 nm or more and 1 µm or less. The transparent conductive film 2 may be formed over the entire surface of the translucent base plate 1 or may be formed on part of the surface of the translucent base plate 1 as illustrated in FIG. 1.

### <First conductive layer 5>

The first conductive layer 5 is a layer that functions as a charge transport layer and is formed of an n-type semiconductor. In this embodiment, the first conductive layer 5 consists of two layers: the foundation layer 3 and the porous semiconductor layer 4. However, the first conductive layer 5 is not limited to this and may be one layer formed of an n-type semiconductor.

### <Foundation layer 3>

The foundation layer 3 is an optionally provided layer. Providing the foundation layer 3 prevents the translucent base plate 1 and the transparent conductive film 2 from being in direct contact with the porous semiconductor layer 4. This prevents the loss of electromotive force, thus ensuring the improvement in photoelectric conversion efficiency of the photoelectric conversion element 100.

The foundation layer 3 may be, for example, a porous film or a dense film so long as it is formed of an n-type semiconductor. However, from a viewpoint of sufficiently preventing the translucent base plate 1 and the transparent conductive film 2 from being in contact with the porous semiconductor layer 4, the foundation layer 3 is preferably a non-porous dense film. No specific limitations are placed on the thickness of the foundation layer 3. The thickness of the foundation layer 3 can be set to, for example, 1 nm or more and 500 nm or less. The foundation layer 3 may optionally contain insulating materials other than the n-type semiconductor, in a proportion without sacrificing the property as an n-type semiconductor of the foundation layer 3.

### <Porous semiconductor layer 4>

The porous semiconductor layer 4 is a porous layer. The first conductive layer 5 including the porous semiconductor layer 4 can more improve the photoelectric conversion efficiency of the photoelectric conversion element 100.

No specific limitations are placed on the thickness of the porous semiconductor layer 4. However, the thickness of the porous semiconductor layer 4 is normally 5 nm or more, preferably 10 nm or more, and is normally 500 nm or less, preferably 100 nm or less. The porous semiconductor layer 4 may be formed of one layer as illustrated in FIG. 1 or a plurality of layers.

### <Power generation layer 6>

The power generation layer 6 is a layer formed of a material that generates electromotive force by absorbing light, preferably a layer containing a perovskite compound, and more preferably a layer consisting of the perovskite compound (perovskite layer).

No specific limitations are placed on the perovskite compound that constitutes the power generation layer 6, and a commonly known perovskite compound can be used. Specific examples of the perovskite compound include lead-based perovskite compounds such as CH₃NH₃PbI₃, CH₃NH₃PbBr₃, (CH₃(CH₂)nCHCH₃NH₃)₂Pbl₄ [n = 5 to 8], and (C₆H₅C₂H₄NH₃)₂PbBr₄, and non-lead-based perovskite compounds. The perovskite compound that constitutes the power generation layer 6 is not limited to lead-based and non-lead-based perovskite compounds and may be a compound that forms a perovskite structure and functions as a power generation layer.

No specific limitations are placed on the thickness of the power generation layer 6. However, the thickness of the power generation layer 6 is preferably 100 nm or more, more preferably 200 nm or more, and is preferably 1 µm or less, more preferably 800 nm or less. The power generation layer 6 with a thickness of 100 nm or more can increase the electromotive force of the power generation layer 6.

### <Second conductive layer 7>

The second conductive layer 7 is a layer consisting of a porous layer containing at least a carbon nanotube fiber body. No specific limitations are placed on the carbon nanotube fiber body contained in the second conductive layer 7. However, the second conductive layer 7 preferably contains nanotubes (hereinafter, also referred to as "CNTs"). The CNTs contained in the second conductive layer 7 preferably contains single-walled CNTs. With such configuration, the photoelectric conversion efficiency of the photoelectric conversion element 100 can be increased.

The second conductive layer 7 is also preferably a layer consisting of a porous self-supporting sheet. Using the porous self-supporting sheet that is a free-standing film can improve the shape stability of the second conductive layer 7. Moreover, the porous self-supporting sheet can be easily produced, thus ensuring easy achievement of a large-area photoelectric conversion element 100. Furthermore, using the porous self-supporting sheet that is porous can easily dry a solvent or a solution when wet processing is performed. The porous self-supporting sheet requires containing at least a carbon nanotube fiber body, preferably contains at least single-walled CNTs as the carbon nanotube fiber body, more preferably is a sheet formed of the carbon nanotube fiber body, more preferably is a sheet formed of the single-walled CNTs, and more preferably is a sheet formed of buckypaper. Using the porous self-supporting sheet containing the carbon nanotube fiber body having at least P-type semiconductor property can apply an excellent function as a hole transport layer and a function as a current-collecting electrode to the second conductive layer 7.

The carbon nanotube fiber body contained in the second conductive layer 7 (more preferably the porous self-supporting sheet) preferably contains a carbon nanotube fiber body having the following properties (more preferably CNTs, and more preferably, single-walled CNTs).

### -(3σ/Av)-

In the carbon nanotube fiber body contained in the second conductive layer 7, a ratio (3σ/Av) of a value (3σ) obtained by the standard deviation (σ) of the diameter by 3 to the average diameter (Av) is preferably more than 0.20, more preferably more than 0.25, and further preferably more than 0.50, and is preferably less than 0.60. When 3σ/Av is more than 0.20 and less than 0.60, even if the amount of the carbon nanotube fiber body contained in the second conductive layer 7 is small, the carbon nanotube fiber body can apply a sufficient function as a hole transport layer and a function as a current-collecting electrode to the second conductive layer 7.

### -Average diameter (Av) of carbon nanotube fiber body-

The average diameter (Av) of the carbon nanotube fiber body is preferably 0.5 nm or more, more preferably 1 nm or more, and is preferably 15 nm or less, more preferably 10 nm or less. When the average diameter (Av) of the carbon nanotube fiber body is 0.5 nm or more, the aggregation of the carbon nanotube fiber body can be suppressed to increase the dispersibility of the carbon nanotube fiber body in the second conductive layer 7. When the average diameter (Av) of the carbon nanotube fiber body is 15 nm or less, the second conductive layer 7 can sufficiently exercise the function as a current-collecting electrode.

### -t-plot-

The carbon nanotube fiber body preferably has a t-plot obtained from the adsorption isotherm that exhibits a convex upward shape. As such carbon nanotube fiber body, a carbon nanotube fiber body that has not undergone opening formation treatment of the single-walled CNTs is more preferable. Using the carbon nanotube fiber body having a t-plot obtained from the adsorption isotherm that exhibits a convex upward shape can obtain a second conductive layer 7 with excellent strength.

The inflection point of the t-plot of the carbon nanotube fiber body is preferably in a range that satisfies 0.2 ≤ t (nm) ≤ 1.5, more preferably in a range of 0.45 ≤ t (nm) ≤ 1.5, and further preferably in a range of 0.55 ≤ t (nm) ≤ 1.0.

The measurement of the adsorption isotherm, the creation of the t-plot, and the analysis of the t-plot of the carbon nanotube fiber body can be performed using, for example, "BELSORP^{®}-mini (BELSORP is a registered trademark in Japan, other countries, or both)" (produced by Bel Japan Inc.), which is a commercially available measurement device.

The carbon nanotube fiber body having the above-described properties can be efficiently produced, for example, by forming a catalyst layer on the surface of a substrate by wet processing in a method (super growth method; see WO2006/011655A1) wherein, during synthesis of a carbon nanotube fiber body through chemical vapor deposition (CVD) by supplying a feedstock compound and a carrier gas onto a substrate having thereon a catalyst layer for carbon nanotube fiber body production, the catalytic activity of the catalyst layer is dramatically improved by providing a trace amount of an oxidizing agent (catalyst activating material) in the system.

Particularly, from a viewpoint of easily obtaining a second conductive layer 7 with large film thickness, a carbon nanotube fiber body obtained by the super growth method is preferably used as the carbon nanotube fiber body.

Furthermore, the second conductive layer 7 preferably contains a material (for example, perovskite compound) that constitutes the above-described power generation layer 6 inside the second conductive layer 7. In more detail, the second conductive layer 7 preferably contains a material (for example, perovskite compound) that constitutes the power generation layer 6 inside a plurality of pores of the second conductive layer 7.

The percentage of the carbon nanotube fiber body contained in the second conductive layer 7 is not specifically limited, but is preferably 50 mass% or more, and is preferably 75 mass% or more.

Examples of the materials other than the carbon nanotube fiber body, which may be optionally contained in the second conductive layer 7, include organic materials and inorganic materials as a P-type semiconductor.

Examples of the organic material that may be contained in the second conductive layer 7 include 2,2',7,7'-tetrakis(N,N-di-p-methoxyphenylamino)-9,9'-spirobifluorene (spiro-MeOTAD), poly(3-hexylthiophene) (P3HT), and polytriallylamine (PTAA).

Examples of the inorganic material that may be contained in the second conductive layer 7 include CuI, CuSCN, CuO, and CuzO.

The film thickness of the second conductive layer 7 is, in general, preferably 20 µm or more, preferably 30 µm or more, and is preferably 200 µm or less, more preferably 80 µm or less. When the film thickness of the second conductive layer 7 is 20 µm or more and 200 µm or less, the second conductive layer 7 can exercise more excellent function as a current-collecting electrode.

### <<Method of producing second conductive layer 7»

No specific limitations are placed on the method of producing the second conductive layer 7. For example, it is possible to adopt a method including a step (film formation step) of forming a second conductive layer 7 by removing a solvent from a carbon nanotube fiber body dispersion liquid containing a carbon nanotube fiber body, a dispersant, and the solvent. Furthermore, the method of producing the second conductive layer 7 may optionally include, prior to the film formation step, a step (dispersion liquid preparation step) of preparing the carbon nanotube fiber body dispersion liquid by subjecting a crude dispersion containing the carbon nanotube fiber body, the dispersant, and the solvent to dispersion treatment.

### -Dispersion liquid preparation step-

In the dispersion liquid preparation step, it is preferable that the crude dispersion containing the carbon nanotube fiber body, the dispersant, and the solvent is subjected to dispersion treatment that brings about a cavitation effect or a crushing effect, which is not particularly limited but is described below in detail, to disperse the carbon nanotube fiber body, thus preparing a carbon nanotube fiber body dispersion liquid. In this way, performing the dispersion treatment that brings about a cavitation effect or a crushing effect can obtain a carbon nanotube fiber body dispersion liquid in which the carbon nanotube fiber body is well dispersed. When the second conductive layer 7 is produced using the carbon nanotube fiber body dispersion liquid in which the carbon nanotube fiber body is well dispersed, by uniformly dispersing the carbon nanotube fiber body, a second conductive layer 7 with excellent characteristics such as electrical conductivity, thermal conductivity, and mechanical characteristics can be obtained. The carbon nanotube fiber body dispersion liquid used for producing the second conductive layer 7 may be prepared by dispersing the carbon nanotube fiber body in a solvent using a commonly known dispersion treatment other than the above.

The carbon nanotube fiber body used for preparing the carbon nanotube fiber body dispersion liquid preferably contain the single-walled CNTs or may be a mixture of the single-walled CNTs and a carbon nanotube fiber body (for example, multi-walled CNTs) other than the single-walled CNTs.

In the carbon nanotube fiber body dispersion liquid, the proportional content of the single-walled CNTs and the carbon nanotube fiber body other than the single-walled CNTs can be set to, for example, 50/50 to 75/25 in mass ratio (single-walled CNTs/carbon nanotube fiber body other than single-walled CNT).

### =Dispersant=

No specific limitations are placed on the dispersant used for preparing the carbon nanotube fiber body dispersion liquid so long as it can disperse the carbon nanotube fiber body and is soluble in a solvent used for preparing the carbon nanotube fiber body dispersion liquid. Examples of such dispersant to be used include a surfactant, a synthetic polymer, or a natural polymer.

Examples of the surfactant include sodium dodecylsulfonate, sodium deoxycholate, sodium cholate, and sodium dodecylbenzenesulfonate.

Examples of the synthetic polymer include polyether diol, polyester diol, polycarbonate diol, polyvinyl alcohol, partially saponified polyvinyl alcohol, acetoacetyl group-modified polyvinyl alcohol, acetal group-modified polyvinyl alcohol, butyral group-modified polyvinyl alcohol, silanol group-modified polyvinyl alcohol, ethylene-vinyl alcohol copolymer, ethylene-vinyl alcohol-vinyl acetate copolymer resin, dimethylaminoethyl acrylate, dimethylaminoethyl methacrylate, acrylic resin, epoxy resin, modified epoxy-based resin, phenoxy resin, modified phenoxy-based resin, phenoxy ether resin, phenoxy ester resin, fluorine-based resin, melamine resin, alkyd resin, phenol resin, polyacrylamide, polyacrylic acid, polystyrene sulfonate, polyethylene glycol, and polyvinyl pyrrolidone.

Examples of the natural polymer include polysaccharides such as starch, pullulan, dextran, dextrin, guar gum, xanthan gum, amylose, amylopectin, alginic acid, gum arabic, carrageenan, chondroitin sulfate, hyaluronic acid, curdlan, chitin, chitosan, and cellulose, and salts or derivatives thereof. The term "derivatives" refers to conventional commonly known compounds such as esters and ethers.

One of these dispersants may be used individually, or two or more of these dispersants may be used as a mixture. Of these dispersants, with excellent dispersibility of the carbon nanotube fiber body, the surfactant is preferable, and sodium deoxycholate or the like is more preferable, as the dispersant.

### =Solvent=

Examples of the solvent of the carbon nanotube fiber body dispersion liquid include, but are not specifically limited to, water; alcohols such as methanol, ethanol, n-propanol, isopropanol, n-butanol, isobutanol, t-butanol, pentanol, hexanol, heptanol, octanol, nonanol, decanol, and amyl alcohol; ketones such as acetone, methyl ethyl ketone, and cyclohexanone; esters such as ethyl acetate and butyl acetate; ethers such as diethyl ether, dioxane, and tetrahydrofuran; amide polar organic solvents such as N,N-dimethylformamide and N-methylpyrrolidone; and aromatic hydrocarbons such as toluene, xylene, chlorobenzene, orthodichlorobenzene, and paradichlorobenzene. One of these solvents may be used individually, or two or more of these solvents may be used as a mixture.

In the dispersion liquid preparation step, it is preferable to perform, for example, dispersion treatment that brings about a cavitation effect or a crushing effect.

### -Dispersion treatment that brings about cavitation effect-

The dispersion treatment that brings about a cavitation effect is a dispersion method that utilizes shock waves caused by the rupture of vacuum bubbles formed in water when high energy is applied to the liquid. Using this dispersion method can well disperse the carbon nanotube fiber body.

Specific examples of the dispersion treatment that brings about a cavitation effect include a dispersion treatment using ultrasound, a dispersion treatment using a jet mill, and a dispersion treatment using high-shear stirring. Only one of these dispersion treatments may be performed, or a plurality of dispersion treatments may be performed in combination. More specifically, for example, an ultrasonic homogenizer, a jet mill, and a high-shear stirring device are preferably used. Conventional commonly known devices may be used as the aforementioned devices.

In a situation in which the carbon nanotube fiber body is dispersed using an ultrasonic homogenizer, the crude dispersion may be irradiated with ultrasound by the ultrasonic homogenizer. The irradiation time may be set as appropriate in consideration of the amount of the carbon nanotube fiber body and so forth. For example, the irradiation time is preferably 3 minutes or more, more preferably 30 minutes or more, and is preferably 5 hours or less, more preferably 2 hours or less. For example, the output is preferably 20 W or more and 500 W or less, and more preferably 100 W or more and 500 W or less. The temperature is preferably 15°C or more and 50°C or less.

In a situation in which a jet mill is used, the number of treatment repetitions carried out may be set as appropriate in consideration of the amount of the carbon nanotube fiber body and so forth. The number of treatment repetitions is, for example, preferably 2 repetitions or more, more preferably 5 repetitions or more, and is preferably 100 repetitions or less, more preferably 50 repetitions or less. For example, the pressure is preferably 20 MPa or more and 250 MPa or less, and the temperature is preferably 15°C or more and 50°C or less.

In a situation in which high-shear stirring is used, the crude dispersion may be subjected to stirring and shearing using a high-shear stirring device. The rotational speed is preferably as fast as possible. The operating time (i.e., the time during which the device is rotating) is preferably 3 minutes or more and 4 hours or less, the circumferential speed is preferably 5 m/sec or more and 50 m/sec or less, and the temperature is preferably 15°C or more and 50°C or less.

The above-described dispersion treatment that brings about a cavitation effect is more preferably performed at a temperature of 50°C or less. The reason for this is in order to suppress change in concentration that occurs due to volatilization of the solvent.

### -Dispersion treatment that brings about crushing effect-

The dispersion treatment that brings about a crushing effect is even more beneficial because in addition to of course enabling uniform dispersion of the carbon nanotube fiber body in the solvent, dispersion treatment that brings about a crushing effect can also suppress damage to the carbon nanotube fiber body due to shock waves when air bubbles burst compared with the above-described dispersion treatment that brings about a cavitation effect.

The dispersion treatment that brings about a crushing effect can uniformly disperse the carbon nanotube fiber body in the solvent by causing crushing and dispersion of the agglomerate of the carbon nanotube fiber body by imparting shear force on the crude dispersion and by further applying back pressure to the crude dispersion, while cooling the crude dispersion as necessary in order to suppress air bubble formation.

When applying back pressure to the crude dispersion, although the back pressure applied to the crude dispersion may be lowered at once to atmospheric pressure, the pressure is preferably lowered over multiple steps.

### -Film formation step-

In the film formation step, the solvent is removed from the above-described carbon nanotube fiber body dispersion liquid to form a second conductive layer 7. Specifically, in the film formation step, for example, using any method of (A) and (B) below, the solvent is removed from the carbon nanotube fiber body dispersion liquid to form a porous self-supporting sheet to be the second conductive layer 7:
(A) a method involving applying the carbon nanotube fiber body dispersion liquid onto a film formation substrate and then drying the applied carbon nanotube fiber body dispersion liquid; and
(B) a method involving filtering the carbon nanotube fiber body dispersion liquid using a film formation substrate that is porous and then drying the resultant residue.

### [Film formation substrate]

The film formation substrate is not specifically limited, and any known substrate may be used.

Specific examples of the film formation substrate onto which the carbon nanotube fiber body dispersion liquid is applied method (A) include a resin substrate and a glass substrate. Examples of the resin substrates can include substrates made of polyethylene terephthalate (PET), polyethylene naphthalate (PEN), polytetrafluoroethylene (PTFE), polyimides, polyphenylene sulfide, aramids, polypropylene, polyethylene, polylactic acid, polyvinyl chloride, polycarbonates, polymethyl methacrylate, alicyclic acrylic resins, cycloolefin resins, and triacetyl cellulose. Examples of the glass substrates can include a substrate made from normal soda glass.

Examples of the film formation substrate used to filter the carbon nanotube fiber body dispersion liquid in method (B) include filter paper and porous sheets made of cellulose, nitrocellulose, alumina, and the like.

### [Application]

In method (A), the carbon nanotube fiber body dispersion liquid can be applied onto the film formation substrate by any commonly known application method. Specific examples of the application method that can be used include dipping, roll coating, gravure coating, knife coating, air knife coating, roll knife coating, die coating, screen printing, spray coating, and gravure offset.

### [Filtration]

In method (B), the carbon nanotube fiber body dispersion liquid can be filtered by the film formation substrate by any commonly known filtration method. Specific examples of the filtration method that can be used include natural filtration, vacuum filtration, pressure filtration, and centrifugal filtration.

### [Drying]

The carbon nanotube fiber body dispersion liquid applied onto the film formation substrate in method (A) or the residue obtained in method (B) can be dried by any commonly known drying method. Examples of the drying method that can be used include hot-air drying, vacuum drying, hot-roll drying, and infrared irradiation. Although no specific limitations are placed on the drying temperature and time, the drying temperature is normally from room temperature to 200°C and the drying time is normally from 0.1 minutes to 150 minutes.

### [Post-treatment]

The porous self-supporting sheet formed in the manner described above normally contains components of the carbon nanotube fiber body dispersion liquid, such as the carbon nanotube fiber body and the dispersant, in the same ratio as these components are contained in the carbon nanotube fiber body dispersion liquid. Accordingly, the method of producing the second conductive layer 7 may optionally include washing the porous self-supporting sheet formed in the film formation step to remove the dispersant from the porous self-supporting sheet. Removal of the dispersant from the porous self-supporting sheet enables further improvement of porous self-supporting sheet properties such as electrical conductivity.

The washing of the porous self-supporting sheet can be performed by bringing the porous self-supporting sheet into contact with a solvent that can dissolve the dispersant and causing the dispersant in the porous self-supporting sheet to elute into the solvent. No specific limitations are placed on the solvent that can dissolve the dispersant in the porous self-supporting sheet. For example, any of the previously described solvents that can be used as the solvent of the carbon nanotube fiber body dispersion liquid may be used, and preferably the same solvent as the solvent of the carbon nanotube fiber body dispersion liquid is used. The porous self-supporting sheet can be brought into contact with the solvent by immersing the porous self-supporting sheet in the solvent or applying the solvent onto the porous self-supporting sheet. Moreover, the porous self-supporting sheet resulting from this washing may be dried by a known method.

Furthermore, for producing the porous self-supporting sheet, adjustment of air gap may be optionally performed as necessary, for example, by subjecting the porous self-supporting sheet formed in the film formation step to pressing in order to further increase the density of the porous self-supporting sheet. From a viewpoint of suppressing deterioration of properties due to damage or destruction of the carbon nanotube fiber body, it is preferable that pressing is performed with a pressing pressure of less than 3 MPa, and more preferable that pressing is not performed.

### <Polymeric layer 8>

The polymeric layer 8 provided between the power generation layer 6 and the second conductive layer 7 is a layer formed of a polymer with a weight-average molecular weight of 20,000 or more and 200,000 or less. The polymeric layer 8 is preferably present in a state in at least partial contact with both of the power generation layer 6 and the second conductive layer 7. No specific limitations are placed on the polymer that constitutes the polymeric layer 8, and a commonly known polymer can be used. With such configuration, the polymeric layer 8 can function as a buffer layer, resulting in the shape stability of a joining surface while suppressing the reduction in performance of the photoelectric conversion element 100.

The polymer that constitutes the polymeric layer 8 is not specifically limited so long as it can improve the close adherence without inhibiting charge transport on the interface. In this regard, the polymer that constitutes the polymeric layer 8 is preferably a hydrogenated polymer, more preferably a polymer having a hydrogenated aromatic or diene skeleton at the main chain, and more preferably one or more selected from the group consisting of a hydrogenated aromatic vinyl compound-conjugated diene block copolymer and a modified product by a silicon atom-containing polar group of a hydrogenated aromatic vinyl compound-conjugated diene block copolymer. The hydrogenated aromatic vinyl compound-conjugated diene block copolymer preferably has a structure with both of the non-aromatic carbon-carbon unsaturated bond and the aromatic carbon-carbon unsaturated bond hydrogenated.

Examples of the polymer that constitutes the polymeric layer 8 can include ethylene-α-olefin copolymers such as an ethylene-propylene copolymer; ethylene-α-olefin-polyene copolymers; copolymers of ethylene and unsaturated carboxylic ester, such as ethylene-methyl methacrylate and an ethylene-butyl acrylate copolymer; copolymers of ethylene and vinyl fatty acid, such as an ethylene-vinyl acetate copolymer; polymers of acrylic acid alkyl ester, such as ethyl acrylate, butyl acrylate, hexyl acrylate, 2-ethylhexyl acrylate, and lauryl acrylate; diene-based copolymers such as polybutadiene, polyisoprene, an acrylonitrile-butadiene copolymer, a butadiene-isoprene copolymer, a butadiene-(meth)acrylic acid alkyl ester copolymer, a butadiene-(meth)acrylic acid alkyl ester-acrylonitrile copolymer, and a butadiene-(meth)acrylic acid alkyl ester-acrylonitrile-styrene copolymer; butylene-isoprene copolymers; aromatic vinyl compound-conjugated diene copolymers such as a styrene-butadiene random copolymer, a styrene-isoprene random copolymer, a styrene-butadiene block copolymer, a styrene-butadiene-styrene block copolymer, a styrene-isoprene block copolymer, and a styrene-isoprene-styrene block copolymer; hydrogenated aromatic vinyl compound-conjugated diene copolymers such as a hydrogenated styrene-butadiene random copolymer, a hydrogenated styrene-isoprene random copolymer, a hydrogenated styrene-butadiene block copolymer, a hydrogenated styrene-butadiene-styrene block copolymer, a hydrogenated styrene-isoprene block copolymer, and a hydrogenated styrene-isoprene-styrene block copolymer; low-crystallinity polybutadiene; a styrene-grafted ethylene-propylene elastomer; a thermoplastic polyester elastomer; and an ethylene-based ionomer. One of these thermoplastic elastomers may be used individually, or two or more of these thermoplastic elastomers may be used in combination in a freely selected ratio.

The hydrogenated aromatic vinyl compound-conjugated diene block copolymer is preferable as the polymer to achieve the desired effects of this disclosure. The hydrogenated aromatic vinyl compound-conjugated diene block copolymer refers to a hydride of an aromatic vinyl compound-conjugated diene block copolymer. In other words, the hydrogenated aromatic vinyl compound-conjugated diene block copolymer refers to a polymer having a structure obtained by hydrogenating part or all of the non-aromatic carbon-carbon unsaturated bond or the aromatic carbon-carbon unsaturated bond of the aromatic vinyl compound-conjugated diene block copolymer, or the both. However, the aforementioned hydride is not limited by its production method.

Styrene and derivatives thereof; and vinylnaphthalene and derivatives thereof are preferable as the aromatic vinyl compound. It is particularly preferable to use styrene in terms of industrial availability. On the other hand, chain conjugated diene (linear conjugated diene, branched conjugated diene) is preferable as the conjugated diene. Preferable examples of the conjugated diene include 1,3-butadiene, isoprene(2-methyl-1,3-butadiene), 2,3-dimethyl-1,3-butadiene, and 1,3-pentadiene. Of these conjugated dienes, 1,3-butadiene and isoprene are particularly preferable in terms of industrial availability.

When a mass fraction of the all aromatic vinyl monomer units in the entire aromatic vinyl compound-conjugated diene block copolymer is w_{A} and a mass fraction of the all conjugated diene monomer units in the entire aromatic vinyl compound-conjugated diene block copolymer is w_{B}, the ratio (w_{A}/w_{B}) of w_{A} to w_{B} is preferably within a specific range. Specifically, the aforementioned ratio (w_{A}/w_{B}) is preferably 20/80 or more, more preferably 30/70 or more, and is preferably 60/40 or less, more preferably 55/45 or less. When the ratio w_{A}/w_{B} is at least the lower limit of any of the ranges set forth above, the heat resistance of the polymeric layer 8 can be improved. When the ratio w_{A}/w_{B} is no higher than the upper limit of any of the ranges set forth above, the flexibility of the polymeric layer 8 can be increased. When the ratio (w_{A}/w_{B}) is within any of the ranges set forth above, the temperature range in which the polymeric layer 8 has rubber elasticity can be extended, thus extending the temperature range in which the photoelectric conversion element 100 has flexibility.

As the aromatic vinyl compound-conjugated diene block copolymer, a polymer selected from a styrene-butadiene block copolymer, a styrene-butadiene-styrene block copolymer, a styrene-isoprene block copolymer, a styrene-isoprene-styrene block copolymer, and mixtures thereof is preferable. More specific examples thereof include aromatic vinyl compound-conjugated diene block copolymers described in technical literatures such as JPH02-133406A, JPH02-305814A, JPH03-72512A, JPH03-74409A, and WO2015/099079A1.

The percent hydrogenation of the hydrogenated aromatic vinyl compound-conjugated diene block copolymer is preferably 90% or more, more preferably 97% or more, and particularly preferably 99% or more. A higher percent hydrogenation can improve the heat resistance and light resistance of the polymeric layer 8. The percent hydrogenation of the hydride can be determined through the measurement by 1H-NMR.

The percent hydrogenation of the non-aromatic carbon-carbon unsaturated bond of the hydrogenated aromatic vinyl compound-conjugated diene block copolymer is preferably 95% or more, more preferably 99% or more. When the percent hydrogenation of the non-aromatic carbon-carbon unsaturated bond is high, the light resistance and oxidation resistance of the polymeric layer 8 can be further increased.

The percent hydrogenation of the aromatic carbon-carbon unsaturated bond of the hydrogenated aromatic vinyl compound-conjugated diene block copolymer is preferably 90% or more, more preferably 93% or more, and particularly preferably 95% or more. When the percent hydrogenation of the aromatic carbon-carbon unsaturated bond is high, the glass-transition temperature of the hydride is high, thus ensuring effective increase in the heat resistance of the polymeric layer 8. Furthermore, decreasing the photoelastic coefficient of the polymeric layer 8 can reduce the expression of retardation.

The hydrogenated aromatic vinyl compound-conjugated diene block copolymer particularly preferably has a structure with both of the non-aromatic carbon-carbon unsaturated bond and the aromatic carbon-carbon unsaturated bond hydrogenated.

A particularly preferable block form of the hydrogenated aromatic vinyl compound-conjugated diene block copolymer is a triblock copolymer in which blocks [A] of the aromatic vinyl polymer hydride bind to both ends of a block [B] of the conjugated diene polymer hydride; or a pentablock copolymer in which polymer blocks [B] bind to both ends of a polymer block [A] and further polymer blocks [A] respectively bind to the other ends of the polymer blocks [B]. In particular, being a triblock copolymer of [A]-[B]-[A] is particularly preferable because production of the polymer is simple and the physical property as a thermoplastic elastomer can be set within a desired range.

The hydrogenated aromatic vinyl compound-conjugated diene block copolymer can be produced by, for example, a method described in WO2015/099079A1 or JP2016-204217A.

As the polymer, a polymer having a silicon atom-containing polar group may be used. Examples of such polymer include a modified product by a silicon atom-containing polar group of the polymer exemplified as a polymer that may be used as the thermoplastic elastomer. When the polymer having a silicon-containing polar group is adopted as the thermoplastic elastomer, the close adhesion strength between an organic sealing layer and the other members can be improved.

Hereinafter, the polymer used for a reaction to obtain the aforementioned modified product may be referred to as a "pre-reaction polymer" as appropriate. The modified product may have, for example, a structure obtained by graft polymerization of the pre-reaction polymer with a compound having a silicon atom-containing polar group as a monomer. However, the modified product is not limited to its production method.

As the silicon atom-containing polar group, an alkoxysilyl group is preferable. Examples of the compound having an alkoxysilyl group as the silicon atom-containing polar group include ethylenically unsaturated silane compounds such as vinyltrimethoxysilane, vinyltriethoxysilane, allyltrimethoxysilane, allyltriethoxysilane, dimethoxymethylvinylsilane, diethoxymethylvinylsilane, p-styryltrimethoxysilane, p-styryltriethoxysilane, 3-methacryloxypropyltrimethoxysilane, 3-methacryloxypropylmethyldimethoxysilane, 3-methacryloxypropyltriethoxysilane, 3-methacryloxypropylmethyldiethoxysilane, 3-acryloxypropyltrimethoxysilane, 3-acryloxypropyltriethoxysilane, and 2-norbornene-5-yltrimethoxysilane.

Reacting the pre-reaction polymer with the compound having a silicon atom-containing polar group can introduce the silicon atom-containing polar group into the pre-reaction polymer, thus obtaining a modified product having the silicon atom-containing polar group. When an alkoxysilyl group is introduced as the silicon atom-containing polar group, the introduction amount of the alkoxysilyl group is preferably 0.1 parts by weight or more, more preferably 0.2 parts by weight or more, and further preferably 0.3 parts by weight or more, and is preferably 10 parts by weight or less, more preferably 5 parts by weight or less, and further preferably 3 parts by weight or less, with respect to 100 parts by weight of the pre-reaction polymer. When the introduction amount of the alkoxysilyl group is within any of the ranges set forth above, it is possible to inhibit the degree of crosslinking between alkoxysilyl groups degraded by moisture from excessively increasing, thus maintaining high adhesiveness. Examples of the material having an alkoxysilyl group used for introducing an alkoxysilyl group, and the modification method include those described in WO2015/099079A1.

The introduction amount of the polar group may be measured by 1H-NMR spectroscopy. In the measurement of the introduction amount of the polar group, in the case of a small introduction amount, the introduction amount may be measured by increasing the cumulated number.

Of these above-described polymers, from a viewpoint of remarkably achieving the desired effects of this disclosure, one or more of the polymers selected from the group consisting of a hydrogenated aromatic vinyl compound-conjugated diene block copolymer and a modified product by a silicon atom-containing polar group of a hydrogenated aromatic vinyl compound-conjugated diene block copolymer are preferable. Of these polymers, a modified product by a silicon atom-containing polar group of a hydrogenated aromatic vinyl compound-conjugated diene block copolymer is particularly preferable.

Of the modified product by a silicon atom-containing polar group of a hydrogenated aromatic vinyl compound-conjugated diene block copolymer, a modified product obtained by introducing an alkoxysilyl group as a silicon atom-containing polar group is preferable. In general, introducing an alkoxysilyl group as a polar group into the pre-reaction polymer such as a hydrogenated aromatic vinyl compound-conjugated diene block copolymer may be referred to as silane modification. In the silane modification, an alkoxysilyl group may be directly bound to the pre-reaction polymer, or an alkoxysilyl group may be bound to the pre-reaction polymer via, for example, a bivalent organic group such as an alkylene group. Hereinafter, the polymer obtained by the silane modification of the pre-reaction polymer is also referred to as a "silane-modified product".

Accordingly, as the modified product by a silicon atom-containing polar group of a hydrogenated aromatic vinyl compound-conjugated diene block copolymer, a silane-modified product of the hydrogenated aromatic vinyl compound-conjugated diene block copolymer is preferable. Of the silane-modified product, one or more of the silane-modified products selected from the group consisting of a silane-modified product of a hydrogenated styrene-butadiene block copolymer, a silane-modified product of a hydrogenated styrene-butadiene-styrene block copolymer, a silane-modified product of a hydrogenated styrene-isoprene block copolymer, and a silane-modified product of a hydrogenated styrene-isoprene-styrene block copolymer are particularly preferable.

No specific limitations are placed on the weight-average molecular weight (Mw) of the polymer. However, the weight-average molecular weight (Mw) of the polymer is preferably 20,000 or more, more preferably 30,000 or more, and further preferably 35,000 or more, and is preferably 200,000 or less, more preferably 100,000 or less, and further preferably 70,000 or less. The weight-average molecular weight of the thermoplastic elastomer may be measured as a value in terms of polystyrene by gel permeation chromatography using tetrahydrofuran as a solvent. The molecular weight distribution (Mw/Mn) of thermoplastic elastomer is preferably 4 or less, more preferably 3 or less, and further preferably 2 or less, and is preferably 1 or more. When the weight-average molecular weight Mw and the molecular weight distribution Mw/Mn of the thermoplastic elastomer are within any of the ranges set forth above, the mechanical strength and heat resistance of the polymeric layer 8 can be improved.

No specific limitations are placed on the glass-transition temperature of the thermoplastic elastomer. However, the glass-transition temperature of the thermoplastic elastomer is preferably 40°C or more, more preferably 70°C or more, and is preferably 200°C or less, more preferably 180°C or less, and further preferably 160°C or less. When a thermoplastic elastomer containing a block copolymer is used, the adhesiveness and the flexibility of the polymeric layer 8 can be balanced by changing the weight ratio of the respective polymer blocks to adjust the glass-transition temperature. The glass-transition temperature of the resin may be measured by increasing the temperature at 10°C/min using a differential scanning calorimeter (DSC).

The second conductive layer 7 may internally contain the above-described materials that constitute the polymeric layer 8. The power generation layer 6 may internally contain the above-described materials that constitute the polymeric layer 8.

The above-described photoelectric conversion element 100 can achieve the function as a hole transport layer and the function as a current-collecting electrode with the second conductive layer 7 alone. The photoelectric conversion element 100 can achieve excellent structural stability and photoelectric conversion efficiency since it includes the polymeric layer 8 as a buffer layer between the power generation layer 6 and the second conductive layer 7.

The presently disclosed photoelectric conversion element is an integrated product of a laminate in which the order of the above-described respective components is maintained. The photoelectric conversion element may further include other layers and the like to an extent that does not impair the effects of this disclosure, so long as the second conductive layer consists of a porous layer containing at least a carbon nanotube fiber body, and a polymeric layer formed of a polymer with a weight-average molecular weight of 20,000 or more and 200,000 or less is provided between the power generation layer and the second conductive layer. The presently disclosed photoelectric conversion element may include an extraction electrode formed of one or more other conductive materials to extract the electricity collected at the second conductive layer to the outside of the photoelectric conversion element.

### (Method of producing photoelectric conversion element)

No specific limitations are placed on the method of producing the photoelectric conversion element 100 in the above-described embodiment. For example, the photoelectric conversion element 100 can be produced by a method including a step (hereinafter, also referred to as a step O) of, after stacking the polymeric layer 8 on the power generation layer 6, in a state where at least one joining surface of a porous self-supporting sheet to be the second conductive layer 7, and the polymeric layer 8 keeps a solvent (hereinafter, also referred to as a solvent X), stacking the porous self-supporting sheet on the polymeric layer 8. The photoelectric conversion element 100 may be produced by a method including a step (hereinafter, also referred to as a step P) of, in a state where at least one joining surface of a porous self-supporting sheet to be the second conductive layer 7, and the power generation layer 6 keeps a solution (hereinafter, also referred to as a solution Y) in which a polymer to form the polymeric layer 8 is dissolved, stacking the porous self-supporting sheet on the power generation layer 6. In the case of any method, the method of producing the photoelectric conversion element 100 may further include a step of drying the solvent X or the solution Y. The above-described "joining surface" refers to a surface on the side where the power generation layer 6 corresponds to the porous self-supporting sheet. The method of producing the photoelectric conversion element 100 will be specifically described below.

### <Preparation of translucent base plate 1>

In the method of producing the photoelectric conversion element 100, the translucent base plate 1 is first prepared. The type of the translucent base plate 1 can be any of the examples previously described in the "Photoelectric conversion element" section.

### <Formation of transparent conductive film 2>

The transparent conductive film 2 is then formed on the translucent base plate 1. No specific limitations are placed on the method of forming the transparent conductive film 2. For example, a commonly known method such as a sputtering method and an evaporation method can be adopted. By using a commercially available translucent base plate in which a transparent conductive film is formed on the surface, the formation of the transparent conductive film 2 may be omitted.

### <Formation of first conductive layer 5>

Furthermore, the first conductive layer 5 is formed on the transparent conductive film 2. The first conductive layer 5 is obtained by forming the foundation layer 3 on the transparent conductive film 2 and then forming the porous semiconductor layer 4.

### [Formation of foundation layer 3]

No specific limitations are placed on the method of forming the foundation layer 3. For example, the foundation layer 3 can be formed by spraying the transparent conductive film 2 with a solution containing a material that forms an n-type semiconductor and then heating it, as necessary.

Examples of the method of spraying fine particles include spray pyrolysis, aerosol deposition, electrostatic spraying, and cold spraying.

### [Formation of porous semiconductor layer 4]

No specific limitations are placed on the method of forming the porous semiconductor layer 4. For example, the porous semiconductor layer 4 can be formed by applying a solution containing a precursor of an n-type semiconductor onto the foundation layer 3 by spin coating or the like and then drying it.

Examples of the precursor of an n-type semiconductor include titanium alkoxides such as titanium tetrachloride (TiCl₄), peroxotitanic acid (PTA), titanium ethoxide, and titanium isopropoxide (TTIP); and metallic alkoxides such as zinc alkoxide, alkoxysilane, zirconium alkoxide, and titanium diisopropoxide bis(acetylacetonate).

Examples of the solvent used for the solution containing a precursor of an n-type semiconductor include, but are not specifically limited to, an alcohol solution such as ethanol.

Furthermore, no specific limitations are placed on the temperature and time when the solution applied onto the foundation layer 3 is dried. The temperature and time may be adjusted as appropriate depending on the type of the n-type precursor or the type of the solvent to be used.

### <Formation of power generation layer 6>

The power generation layer 6 is subsequently formed on the first conductive layer 5. Examples of the method of forming the power generation layer 6 include, but are not specifically limited to, a vacuum evaporation method and an application method. The power generation layer 6 can be formed by applying a precursor-containing solution containing a precursor of a perovskite compound onto the first conductive layer 5 and then firing it. Examples of the precursor of a perovskite compound include lead iodide (PbI₂) and methylammonium iodide (CH₃NH₃I). Examples of the solvent contained in the precursor-containing solution include, but are not specifically limited to, N,N-dimethylformamide and dimethyl sulfoxide. After applying such solution, a poor solvent can be used to promote the precipitation of a perovskite compound. The poor solvent herein refers to a solvent with no substantial change in perovskite compound in the production step. In the production step, it is recognized that there is no substantial change if the perovskite compound has no deterioration in appearance such as clouding of the film by visual observation.

The concentration of the precursor of a perovskite compound in the precursor-containing solution may be set to a suitable concentration as appropriate depending on the solubility or the like of the materials that constitute the perovskite compound and can be set to, for example, around 0.5 M to 1.5 M.

No specific limitations are placed on the method of applying the precursor-containing solution onto the first conductive layer 5. For example, a commonly known application method such as spin coating, spraying, or bar coating can be adopted.

### <Production example of polymer>

Examples of the polymer used in this disclosure includes a polymer synthesized based on the following production example.

### (P1-1. Production of hydrogenated block copolymer)

By using styrene as an aromatic vinyl compound and using isoprene as a chain conjugated diene compound, a hydride of a block copolymer (hydrogenated block copolymer) having a triblock structure in which polymer blocks [A] bind to both ends of a polymer block [B] was produced in the following procedure.

A fully nitrogen-purged reactor quipped with a stirrer was charged with 256 parts of dehydrated cyclohexane, 25.0 parts of dehydrated styrene, and 0.615 parts of n-dibutyl ether. Polymerization was then initiated by adding 1.35 parts of n-butyllithium (15% cyclohexane solution) to the reactor while stirring these materials at 60°C. These materials were reacted at 60°C for 60 minutes while being further stirred. The polymerization conversion rate at this time was 99.5% (The polymerization conversion rate was measured by gas chromatography. The same applies hereinafter.).

Then, 50.0 parts of dehydrated isoprene was added to the reaction liquid, and stirring was continued at the same temperature for 30 minutes. The polymerization conversion rate at this time was 99%. Thereafter, 25.0 parts of dehydrated styrene was further added to the reaction liquid, and the reaction liquid was stirred at the same temperature for 60 minutes. The polymerization conversion rate at this time was almost 100%. Then, 0.5 parts of isopropyl alcohol was added to the reaction liquid to stop the reaction, thus obtaining a solution (i) containing a block copolymer. The weight-average molecular weight (Mw) of the block copolymer in the obtained solution (i) was 44,900, and the molecular weight distribution (Mw/Mn) was 1.03 (They were measured as values in terms of polystyrene by gel permeation chromatography using tetrahydrofuran as a solvent. The same applies hereafter.).

Then, the solution (i) was transferred to a pressure-resistant reactor equipped with a stirrer. To the solution (i), 4.0 parts of nickel catalyst supported on silica-alumina (E22U, carrying amount of nickel: 60%; produced by JGC Chemical Industries, Ltd.) as a hydrogenation catalyst and 350 parts of dehydrated cyclohexane were added and mixed. The reactor was purged with hydrogen gas. Hydrogen was further fed to the reactor while stirring the solution to perform a hydrogenation reaction at a temperature of 170°C under a pressure of 4.5 MPa for 6 hours to hydrogenate the block copolymer, thus obtaining a solution (iii) containing a hydride (ii) of the block copolymer. The weight-average molecular weight (Mw) of the hydride (ii) in the solution (iii) was 45,100, and the molecular weight distribution (Mw/Mn) was 1.04.

After the hydrogenation reaction, the solution (iii) was filtered to remove the hydrogenation catalyst. Thereafter, 1.0 parts of xylene solution in which 0.1 parts of 6-[3-(3-t-butyl-4-hydroxy-5-methylphenyl)propoxy]-2,4,8,10-tetrakis-t-butyldibenzo[d,f][1.3.2]dioxaphosphepin ("SUMILIZER^{®} GP (SUMILIZER is a registered trademark in Japan, other countries, or both)" produced by SUMITOMO CHEMICAL COMPANY, LIMITED; hereinafter, referred to as an "antioxidant A") as a phosphoric antioxidant was dissolved was added to the filtered solution (iii) and dissolved, thus obtaining a solution (iv).

The solution (iv) was then filtered by Zeta Plus^{®} filter 30H (Zeta Plus is a registered trademark in Japan, other countries, or both) (produced by CUNO; pore diameter: 0.5 µm to 1 µm) and sequentially further filtered by another metal fiber filter (pore diameter: 0.4 µm; produced by NICHIDAI CO., LTD.) to remove minute solid contents. Cyclohexane, xylene, and other volatile components as solvents were removed from the filtered solution (iv) using a cylindrical evaporator (product name: "Kontro"; produced by Hitachi Ltd.) at a temperature of 260°C under a pressure of 0.001 MPa or less. Then, the solid contents were extruded into a strand shape in a molten state from a die directly connected to the aforementioned evaporator, cooled, and cut by a pelletizer, thus obtaining 85 parts of pellets (v) containing the hydride of the block copolymer and the antioxidant A. The weight-average molecular weight (Mw) of the hydride of the block copolymer (hydrogenated block copolymer) in the obtained pellets (v) was 45,000, and the molecular weight distribution (Mw/Mn) was 1.08. The percent hydrogenation measured by ¹H-NMR was 99.9%.

### (P1-2. Production of silane-modified product of hydrogenated block copolymer)

To 100 parts of pellets (v) obtained in the step (P1-1), 2.0 parts of vinyltrimethoxysilane and 0.2 parts of di-t-butyl peroxide were added, thus obtaining a mixture. The mixture was kneaded using a twin-screw extruder at a barrel temperature of 210°C with a residence time of 80 seconds to 90 seconds. The kneaded mixture was extruded and cut by a pelletizer, thus obtaining pellets (vi) of a silane-modified product of a hydrogenated block copolymer. When a film-shaped test piece was produced from the pellets (vi) and a glass-transition temperature Tg was evaluated at a peak of tan δ in a device for measuring dynamic viscoelasticity, it was 124°C. The peak value of tan δ at a temperature of 40°C or more and 200°C or less of the pellets (vi) was 1.3. The Young's modulus and the tensile elongation at 23°C of the pellets (vi) were 0.5 GPa and 550%, respectively. The refractive index (n1) measured by an Abbe's refractometer of the pellets (vi) was 1.50.

### <Formation of second conductive layer 7 and polymeric layer 8> «Step O»

When the second conductive layer 7 and the polymeric layer 8 are formed by the step O, after forming the power generation layer 6, the polymeric layer 8 is formed on the power generation layer 6. Thereafter, in a state where at least one joining surface of a porous self-supporting sheet to be the second conductive layer 7, and the polymeric layer 8 keeps the solvent X, the porous self-supporting sheet is stacked on the polymeric layer 8. This can efficiently affix the porous self-supporting sheet to the power generation layer 6.

### [Formation of polymeric layer 8]

No specific limitations are placed on the method of forming the polymeric layer 8. For example, the polymeric layer 8 can be formed by applying the solution Y in which the polymer to form the polymeric layer 8 is dissolved to the power generation layer 6 and then drying it, as necessary.

Examples of the solvent in which the polymer is dissolved include, but are not specifically limited to, poor solvents such as chlorobenzene, toluene, and anisole. The polymer can be any of the examples previously described in the "Polymeric layer" section. The concentration of the polymer in the solution Y can be selected as appropriate according to the method since the liquid volume to be carried differs depending on the application amount or the application method.

No specific limitations are placed on the method of applying the solution Y onto the power generation layer 6. For example, a commonly known application method such as spin coating, spraying, or bar coating can be adopted.

### [Formation of second conductive layer 7]

Examples of the solvent X include, but are not specifically limited to, poor solvents such as chlorobenzene, toluene, and anisole. By using such poor solvent, for example, when the power generation layer 6 is a perovskite layer formed of a perovskite compound, even if the solvent X penetrates to the power generation layer 6 through the polymeric layer 8, the performance of the power generation layer 6 can be maintained.

No specific limitations are placed on the method of keeping the solvent X on at least one joining surface of the porous self-supporting sheet and the polymeric layer 8. For example, the solvent X may be applied to the porous self-supporting sheet, the solvent X may be applied to the polymeric layer 8, or the solvent X may be applied to both of the porous self-supporting sheet and the polymeric layer 8.

In particular, when a porous self-supporting sheet impregnated with the solvent X is used, the solvent X can be well kept on at least one joining surface of the porous self-supporting sheet and the polymeric layer 8.

The porous self-supporting sheet impregnated with the solvent X can be obtained by, for example, immersing a porous self-supporting sheet in the solvent X and then pulling it up. In this case, no specific limitations are placed on the immersion time. The immersion time may be set as appropriate according to the type of the solvent to be used. Moreover, any method such as a method of spraying a porous self-supporting sheet placed on an affixing jig or the like with the solvent X or dropping the solvent X on the porous self-supporting sheet can be selected as appropriate according to an actual production process.

### «Step P»

When the second conductive layer 7 and the polymeric layer 8 are formed by the step P, in a state where at least one joining surface of a porous self-supporting sheet to be the second conductive layer 7, and the power generation layer 6 keeps the solution Y in which the polymer to form the polymeric layer 8 is dissolved, the porous self-supporting sheet is stacked on the power generation layer 6. This can efficiently affix the porous self-supporting sheet to the power generation layer 6.

Examples of the solvent of the solution Y include, but are not specifically limited to, poor solvents such as chlorobenzene, toluene, and anisole, so long as a predetermined amount of the polymer to form the polymeric layer 8 can be dissolved in it. By using such poor solvent, for example, when the power generation layer 6 is a perovskite layer formed of a perovskite compound, the performance of the power generation layer 6 can be maintained. The polymer in the solution Y can be any of the examples previously described in the "Polymeric layer" section. The concentration of the polymer in the solution Y can be selected as appropriate according to the method since the liquid volume to be carried differs depending on the application amount or the application method.

No specific limitations are placed on the method of keeping the solution Y on at least one joining surface of the porous self-supporting sheet and the power generation layer 6. For example, the solution Y may be applied to the porous self-supporting sheet, the solution Y may be applied to the power generation layer 6, or the solution Y may be applied to both of the porous self-supporting sheet and the power generation layer 6.

Specific examples of the method of applying the solution Y to the porous self-supporting sheet include, but are not specifically limited to, applications by dipping, roll coating, gravure coating, knife coating, air knife coating, roll knife coating, die coating, screen printing, spray coating, and gravure offset.

In particular, when a porous self-supporting sheet impregnated with the solution Y is used, the solution Y can be well kept on at least one joining surface of the porous self-supporting sheet and the power generation layer 6.

The porous self-supporting sheet impregnated with the solution Y can be obtained by, for example, immersing a porous self-supporting sheet in the solution Y and then pulling it up. In this case, no specific limitations are placed on the immersion time. The immersion time may be set as appropriate according to the type of the solvent or polymer to be used.

No specific limitations are placed on the method of applying the solution Y to the power generation layer 6. For example, application such as spin coating, spraying, or bar coating can be used.

### <Drying>

After the second conductive layer 7 and the polymeric layer 8 are formed by the step O or the step P, a drying step of drying the porous self-supporting sheet may be provided. The method of drying the porous self-supporting sheet can be any of commonly known drying methods. Examples of the drying method include hot-air drying, vacuum drying, hot-roll drying, infrared irradiation, and hot pressing. The drying temperature and drying time can be selected as appropriate depending on the solvent used for the solvent X or the solution Y or the applied liquid volume. No specific limitations are placed on the drying temperature. However, the drying temperature is preferably at least room temperature, more preferably 80°C or more, and is preferably 200°C or less, more preferably 120°C or less. No specific limitations are placed on the drying time. However, the drying time is preferably 1 second or more, more preferably 10 seconds or more, and is preferably 10 minutes or less, more preferably 1 minute or less.

Of these methods, hot pressing is preferably used. With the hot pressing, a photoelectric conversion element 100 with excellent integrity can be obtained. The pressure in the hot pressing is not specifically limited so long as it has no influence on the substrate or the formed film, and can be set to, for example, 0.01 to 0.5 MPa. The heating temperature and heating time in the hot pressing can be selected as appropriate depending on the solvent used for the solvent X or the solution Y or the applied liquid volume. In the hot pressing, it is preferable to perform pressing in a form of ensuring the volatilization path of the solvent to promote the removal of the solvent components contained in the porous self-supporting sheet. Specifically, to ensure the volatilization path of the solvent, it is preferable to perform hot pressing through a member having air gap, such as thick wipe, porous gum, porous metal, and porous ceramic.

According to the above-described production method, a photoelectric conversion element 100 with excellent structural stability and photoelectric conversion efficiency can be easily produced. The method of producing the photoelectric conversion element 100 is not limited to the above-described method and may include other steps other than the above-described steps to an extent that does not impair the effects of this disclosure.

### EXAMPLES

The following provides a more specific description of the present disclosure based on examples. However, the present disclosure is not limited to the following examples.

### <Production of perovskite solar cell>

A perovskite solar cell as a photoelectric conversion element was produced in the following procedure.

### (Example 1)

[Production of translucent base plate on which transparent conductive film is formed]

Using a conductive glass base plate (produced by Sigma-Aldrich Co. LLC.) obtained by forming a fluorine-doped tin (FTO) film as a transparent conductive film on the surface of a glass base plate, parts of the FTO film was removed by etching. In this way, a translucent base plate on which a transparent conductive film is formed (hereinafter, referred to as a "translucent base plate with a transparent conductive film") was obtained.

### [Formation of first conductive layer]

The surface of the FTO film of the translucent base plate with a transparent conductive film was sprayed with a solution (produced by Sigma-Aldrich Co. LLC.) obtained by dissolving titanium diisopropoxide bis(acetylacetonate) in isopropanol by spray pyrolysis. In this way, a foundation layer (thickness: 30 nm) formed of titanium dioxide was formed on the FTO film. Then, a solution obtained by diluting a titanium oxide paste (produced by Sigma-Aldrich Co. LLC.) with ethanol was prepared. The obtained solution was applied to the surface of the foundation layer by spin coating, and heat treatment was performed at a temperature of 450°C for 30 minutes to form a porous semiconductor layer (thickness: 120 nm) formed of titanium dioxide (TiO₂), thus obtaining a first conductive layer.

### [Formation of power generation layer]

An N,N-dimethylformamide (DMF) solution containing lead iodide (PbI₂) with a concentration of 1.0 M and methylammonium iodide (CH₃NH₃I) with a concentration of 1.0 M was prepared as a solution (1) containing a precursor of a perovskite compound. The obtained solution (1) was applied to the surface of the first conductive layer by spin coating while dropping chlorobenzene, and firing was performed at a temperature of 100°C for 10 minutes to form a perovskite layer (thickness: 450 nm) as a power generation layer.

### [Formation of polymeric layer]

The formed perovskite layer was spin coated with a solution obtained by dissolving 10 mg of a polymer synthesized based on the above-described production example in 1 ml of chlorobenzene and dried on a hot plate at 80°C to form a polymeric layer. This resulted in a pre-press laminate including the translucent base plate with a transparent conductive film/the first conductive layer/the power generation layer (perovskite layer)/the polymeric layer in this order.

### [Production of porous self-supporting sheet]

A porous self-supporting sheet containing single-walled CNTs was produced in the following procedure.

A crude dispersion containing DOC as a dispersant was obtained by adding 1.0 g of single-walled CNTs (produced by Zeon Corporation; product name "ZEONANO SG101"; average diameter: 3.5 nm; G/D ratio: 2.1; convex upward shape in t-plot without opening treatment) as a fibrous carbon nanostructure containing single-walled CNTs to 500 mL of sodium deoxycholate (DOC) 2 mass% aqueous solution as a solvent containing a dispersant. This crude dispersion was charged into a high-pressure homogenizer (produced by Beryu Corp.; product name: "BERYU SYSTEM PRO") having a multi-step pressure control device ("multi-step pressure reducer") for applying a back pressure during dispersion, and the crude dispersion was subjected to dispersion treatment under a pressure of 100 MPa. Specifically, the fibrous carbon nanostructure containing single-walled CNTs was dispersed by imparting shear force on the crude dispersion while applying back pressure and, thus obtaining a fibrous carbon nanostructure dispersion liquid containing single-walled CNTs. The dispersion treatment was performed for 10 minutes while returning a dispersion liquid flown from the high-pressure homogenizer back again to the high-pressure homogenizer.

To a 200-mL beaker, 50 g of the produced fibrous carbon nanostructure dispersion liquid containing single-walled CNTs, and 50 g of distilled water was added to produce a product diluted in twice. Then, filtration was performed at 0.09 MPa using a vacuum filtration device equipped with a membrane filter. After this filtration, isopropyl alcohol and water were passed through the vacuum filtration device to wash a carbon film formed on the membrane filter, and then air was passed through the vacuum filtration device for 15 minutes. After that, the produced carbon film/membrane filter were immersed in ethanol, and the carbon film was peeled from the membrane filter to obtain a carbon film (A).

The obtained carbon film (A) had substantially the same dimension as the membrane filter, had excellent film-forming properties, maintained the film form even after being peeled from the filter, and had excellent free-standing properties. As a result of measuring the film density of the obtained carbon film (A), the density was 0.85 g/cm³. From these results, it was found that the carbon film (A) was a porous self-supporting sheet (A).

### [Formation of second conductive layer]

After the porous self-supporting sheet (A) was immersed in chlorobenzene for 10 seconds, the porous self-supporting sheet (A) was pulled up from the chlorobenzene, thus obtaining a porous self-supporting sheet (1) with chlorobenzene impregnated. The porous self-supporting sheet (1) was stacked on the pre-press laminate heated on a hot plate at a temperature of 80°C. The obtained laminate was dried with being hot pressed via a wipe at a pressure of 0.05 MPa from the side of the porous self-supporting sheet (1), thus obtaining a perovskite solar cell.

### (Example 2)

A perovskite solar cell was produced in accordance with Example 1 except that, without preliminarily forming a polymeric layer on the power generation layer, after the porous self-supporting sheet (A) was immersed for 20 seconds in a solution obtained by dissolving 10 mg of the polymer synthesized based on the above-described production example in 1 ml of chlorobenzene, the porous self-supporting sheet (A) was pulled up from the solution, the porous self-supporting sheet (1) was stacked on the pre-press laminate heated on a hot plate at a temperature of 80°C, and the obtained laminate was dried with being hot pressed via a wipe at a pressure of 0.05 MPa from the side of the porous self-supporting sheet (1).

### (Comparative Example 1)

A perovskite solar cell was produced in accordance with Example 1 except that the porous self-supporting sheet (A) was directly arranged on the perovskite layer without forming a polymeric layer.

### (Example 3)

A perovskite solar cell was produced in accordance with Example 1 except that a polymeric layer was formed on the formed perovskite layer after a Li salt treatment was performed as a surface treatment of the perovskite layer.

### (Comparative Example 2)

A perovskite solar cell was produced in accordance with Example 2 except that the porous self-supporting sheet (A) was directly arranged on the perovskite layer without forming a polymeric layer.

### (Example 4)

A perovskite solar cell was produced in accordance with Example 1 except that the porous self-supporting sheet was produced without using a dispersant.

### (Comparative Example 3)

A perovskite solar cell was produced in accordance with Example 3 except that the porous self-supporting sheet (A) was directly arranged on the perovskite layer without forming a polymeric layer.

### (Example 5)

A perovskite solar cell was produced in accordance with Example 3 except that a polymeric layer was formed on the formed perovskite layer after a Li salt treatment was performed as a surface treatment of the perovskite layer.

### (Comparative Example 4)

A perovskite solar cell was produced in accordance with Example 4 except that the porous self-supporting sheet (A) was directly arranged on the perovskite layer without forming a polymeric layer.

### <Evaluation for structural stability>

Table 1 and Table 2 present the results of inspection of the occurrence of peeling of the second conductive layer immediately after the production of the obtained perovskite solar cell and after a predetermined period of time.

**[Table 1]**

| | Surface treatment of perovskite layer | Presence or absence of polymeric layer | Use or non-use of dispersant in porous self-supporting sheet | Occurrence of peeling immediately after production | Occurrence of peeling after 85 days |
|---|---|---|---|---|---|
| Example 1 | Without | Present | Use | Without | Without |
| Example 2 | Without | Present | Use | Without | Without |
| Comparative Example 1 | Without | Absent | Use | Without | Peeling with 4/10 |
| Example 3 | Li salt treatment | Present | Use | Without | Without |
| Comparative Example 2 | Li salt treatment | Absent | Use | Peeling with 10/10 | - |

| | Surface treatment of perovskite layer | Presence or absence of polymeric layer | Use or non-use of dispersant in porous self-supporting sheet | Occurrence of peeling immediately after production | Occurrence of peeling after 60 days |
|---|---|---|---|---|---|
| Example 4 | Without | Present | Non-use | Without | Without |
| Comparative Example 3 | Without | Absent | Non-use | Without | Peeling with 3/10 |
| Example 5 | Li salt treatment | Present | Non-use | Without | Without |
| Comparative Example 4 | Li salt treatment | Absent | Non-use | Without | Peeling with 4/10 |

From the results presented in Tables 1 and 2, it is found that a perovskite solar cell with excellent structural stability can be produced according to each of the methods in Examples 1 to 4.

### INDUSTRIAL APPLICABILITY

According to the present disclosure, a photoelectric conversion element with excellent structural stability can be provided.

### REFERENCE SIGNS LIST

- 1: translucent base plate
- 2: transparent conductive film
- 3: foundation layer
- 4: porous semiconductor layer
- 5: first conductive layer
- 6: power generation layer
- 7: second conductive layer
- 8: polymeric layer
- 100: photoelectric conversion element

## Claims

1. A photoelectric conversion element formed of an integrated laminate including a translucent base plate, a transparent conductive film, a first conductive layer, a power generation layer, and a second conductive layer in this order, wherein
the second conductive layer consists of a porous layer containing at least a carbon nanotube fiber body, and a polymeric layer formed of a polymer with a weight-average molecular weight of 20,000 or more and 200,000 or less is provided between the power generation layer and the second conductive layer.

2. The photoelectric conversion element according to claim 1, wherein the polymer is a hydrogenated polymer.

3. The photoelectric conversion element according to claim 1 or 2, wherein the polymer is a polymer having a hydrogenated aromatic or diene skeleton at the main chain.

4. The photoelectric conversion element according to any one of claims 1 to 3, wherein the polymer is one or more selected from the group consisting of a hydrogenated aromatic vinyl compound-conjugated diene block copolymer and a modified product by a silicon atom-containing polar group of a hydrogenated aromatic vinyl compound-conjugated diene block copolymer.

5. The photoelectric conversion element according to claim 4, wherein the hydrogenated aromatic vinyl compound-conjugated diene block copolymer has a structure with both of the non-aromatic carbon-carbon unsaturated bond and the aromatic carbon-carbon unsaturated bond hydrogenated.

6. The photoelectric conversion element according to any one of claims 1 to 5, wherein the second conductive layer consists of a porous self-supporting sheet.

7. The photoelectric conversion element according to claim 6, wherein the porous self-supporting sheet has a film thickness of 20 µm or more.

8. The photoelectric conversion element according to any one of claims 1 to 7, wherein the power generation layer contains a perovskite compound.

9. The photoelectric conversion element according to any one of claims 1 to 8, wherein the carbon nanotube fiber body has an average diameter (Av) and a standard deviation (σ) of the diameter that satisfy a relationship 0.20 < (3σ/Av) < 0.60.

10. The photoelectric conversion element according to any one of claims 1 to 9, wherein the carbon nanotube fiber body has a t-plot obtained from the adsorption isotherm that exhibits a convex upward shape.

11. A method of producing the photoelectric conversion element according to any one of claims 1 to 10, the method comprising
after stacking the polymeric layer on the power generation layer, in a state where at least one joining surface of a porous self-supporting sheet to be the second conductive layer, and the polymeric layer keeps a solvent, stacking the porous self-supporting sheet on the polymeric layer.

12. A method of producing the photoelectric conversion element according to any one of claims 1 to 10, the method comprising
in a state where at least one joining surface of a porous self-supporting sheet to be the second conductive layer, and the power generation layer keeps a solution in which a polymer to form the polymeric layer is dissolved, stacking the porous self-supporting sheet on the power generation layer.
